# EUROPEAN PATENT SPECIFICATION

(11) **EP 0 379 828 B1**
(45) Date of publication and mention of the grant of the patent: **27.09.1995**
(21) Application number: 89480185.1
(22) Date of filing: 19.12.1989
(51) Int. Cl.: H01J 37/32, H05H 1/46

(54) **Radio frequency induction/multipole plasma processing tool**
Radiofrequenzinduktion/Mehrpolplasma-Bearbeitungsvorrichtung
Dispositif de traitement par plasma multipolaire à induction de radiofréquence

(30) Priority: 25.01.1989 US 301933
(43) Date of publication of application: 01.08.1990
(73) Proprietor: International Business Machines Corporation, Armonk, N.Y. 10504 (US)
(72) Inventor: Coultas, Dennis Keith, Hopewell Junction New-York 12533 (US); Keller, John Howard, Poughkeepsie New-York 12603 (US)
(74) Representative: Tubiana, Max

(56) References cited:
- EP-A- 0 115 970
- EP-A- 0 184 812
- EP-A- 0 203 560
- EP-A- 0 261 922
- EP-A- 0 284 867
- US-A- 4 431 898

## Description

### BACKGROUND OF THE INVENTION

### Field of the Invention

This invention relates to an apparatus according to the first part of claim 1 for plasma processing of substrates, and more particularly to subtractive (etching) and additive (deposition) processing of electronic circuit chips and packaging materials.

### Technical Problem

The problem with capacitive coupling of R.F. energy to a plasma employed for etching or depositing films is that to increase power to the level required to generate the plasma required, the voltage will be so high that the charged particles in the plasma will be accelerated to an excessive level of kinetic energy and will tend to sputter the work piece and to etch or sputter away any masks. The effect will be to chamfer the mask opening, i.e. increase the size of openings in masks by etching the edges of the masks. The effect also leads to ion damage and loss of selectivity. This is unacceptable as the requirements in the art are to decrease the size of openings as dimensions are decreasing in microelectronics. Instead one would like the flexibility of varying the ion energy according to the desired process.

### Related Art

U.S. patent 3,705,091 of Jacob for "Gas Discharge Apparatus" shows a cylindrical glass reaction chamber coaxially wound with a helical R.F. coil energized by high frequency (13.5 mHz) R.F. to generate a plasma in a vacuum for etching of a tray of semiconductor slices. The system operates in the 1 Torr (1.3 x 10² Pa) pressure range and produces mainly reactive radicals. The Jacob system does not operate in the desired reactive ion etching, RIE mode of this invention. In the pressure range desired for the present invention of 1 to 50 mTorr (1.3 x 10⁻¹to 6,5 Pa), the Jacob system would produce very non-uniform and very slow etching. No means for confining the plasma is shown.

M. C. Vella, K. W. Ehlers, D. Kippenhan, P. A. Pincosy, and R. V. Pyle "Development of R.F. Plasma Generators for Neutral Beams", J. Vac. Sci. Technol. A 3(3), (May/June 1985) pp 1218-1221 describes an R.F. plasma source used to generate a high power neutral beam to heat a large fusion plasma to reaction temperatures. The pressure is from 1 to 20 mTorr (2,6 Pa). A plurality of magnetic dipoles surround the rf bucket chamber to create a magnetic shield for the plasma. There is no reference to additive or substractive treatment of a substrate. Vella et al teaches the use of R.F. induction for plasma production, but it does not teach the use of R.F. induction for etching or deposition where the plasma will etch the coating on an R.F. coil and coat the insulators.

R. Limpaecher and K. R. MacKenzie, "Magnetic Multipole Containment of Large Uniform Collisionless Quiescent Plasmas", Rev. Sci. Instrum., Vol. 44, No. 6, (June 1973) 726-731 discusses the use of magnetic multipoles for confinement of a plasma or argon at a pressure of 0.002 Torr (2.6 x 10⁻¹Pa). This reference is one of the original papers on multipole confinement of the primary electrons in plasma production from electron emission from a hot filament. U.S. patent No. 4,483,737 of Mantei, "Method and Apparatus for Plasma Etching a Substrate" uses an electrically heated filament to emit electrons, but states at Col. 5, lines 53-65, that a hollow cathode or ion cyclotron resonance can be used to generate electrons. Later, it states that R.F. power sources are not used for the discharge current or for generation of the surface magnetic field confining the plasma. At Col. 6, lines 52-58, it states "The plasma is produced by impact from fast ionizing electrons drawn from a set of heated tungsten filaments, rather than by an applied rf voltage."

See also T. D. Mantei and T. Wicker, "Plasma Etching with Surface Magnetic Field Confinement" Appl. Phys. Lett. 43(1), (1 July 1983) pp. 84-86, and T. D. Mantei and T. Wicker, "Low Pressure Plasma Etching with Magnetic Confinement", Solid State Technology (April 1985) pp. 263-265.

I. Lin, D.C. Hinson, W. H. Class, R. L. Sandstrom, "Low-Energy High Flux Reactive Ion Etching by R.F. Magnetron Plasma", Appl. Phys. Lett. Vol. 44 (Jan. 15 1984) pp. 185-187 describes magnetic confinement of a plasma and R.F. power being used for plasma production. The R.F. power is capacitively coupled to a copper prism used as an electrode. This is one of many magnetron reactive ion etching systems. Most of them involve an effort to achieve uniformity from a system in which the electron density increases in the direction of E x B drift of secondary electrons from the cathode. These systems also provide limited adjustability of the energy of the ions striking a wafer.

U.S. patent No. 4,632,719 of Chow et al for "Semiconductor Etching Apparatus with Magnetic Array and Vertical Shield" describes etching a semiconductor wafer in an R.F. field in argon gas. A pair of rings of concentric dipoles above the wafer create a pair of rings in the plasma above the wafer. This leads to the kind of lack of uniformity of the plasma which would be avoided in systems required to provide uniform etching or deposition. Thus the Chow et al patent would lead one in the opposite direction from the purpose to which this invention is directed.
U.S. patent No.4,384,938 "Reactive Ion Etching Chamber" of B. Desilets et al describes a reactive ion etching tool having a cylindrical reactive ion etching chamber acting as an anode and a plate arrangement acting as a cathode and wherein an R.F. signal applied between cathode and anode acts to produce an active glow region within the chamber with a dark space existing over the internal surfaces thereof. A reactive ion etching chamber structure has an internal top surface and sidewall surfaces forming a physically symmetrical arrangement with respect to the cathode plate positioned between the sidewall surfaces below the top surface, the top surface and surfaces being uniform except for gas input and exhaust ports with the gas exhaust ports having an opening dimension less than the thickness of the dark space existing over the internal surface.

EP-A- 184 812 describes a plasma dry processing apparatus according to the first part of claim 1 having a chamber, induction means for providing an RF induction field and confinement means.

EP-A- 261 922, disclose an electrode assembly and apparatus using magnets to trap electrons adjacent the walls of the hole of the electrode producing the plasma.

US-A- 4 431 898 describes an apparatus for plasma etching of semiconductor devices. A plasma chamber is inductively coupled to a source of A.C. power wherein the semiconductor devices are etched.

EP-A- 115 970 describes a plasma etching apparatus comprising on its chamber walls a liner being substantially inert to a plasma.

EP-A- 203 560 discloses a plasma etching apparatus comprising manifold means and orifice means.

See also Keller et al U.S. Patent No. 4,383,177 for "Multipole Implantation Isotope Separation Ion Beam Source".

Objects of this invention are :
a) a uniform plasma,
b) plasma density which does not saturate with power,
c) control of ion energy,
d) high etch rates for a given power level, and
e) relative simplicity.

These objects are provided by means of the apparatus defined in claim 1. The dependent claims describe particular embodiments of the invention.

### BRIEF DESCRIPTION OF THE DRAWINGS

FIG. 1 shows a sectional view of a plasma treatment system in accordance with this invention.

FIG. 2. shows a magnetic multipole arrangement for confinement of a plasma in accordance with this invention.

FIG. 3 shows a schematic diagram of some elements of the plasma system of FIG. 1.

FIG. 4. shows a plan view of the involute or spiral shaped R.F. induction field coil in the system of FIG. 1 in accordance with this invention.

FIG. 5 is a graph of ion current vs R.F. power for three plasma processing systems.

### DESCRIPTION OF THE PREFERRED EMBODIMENT

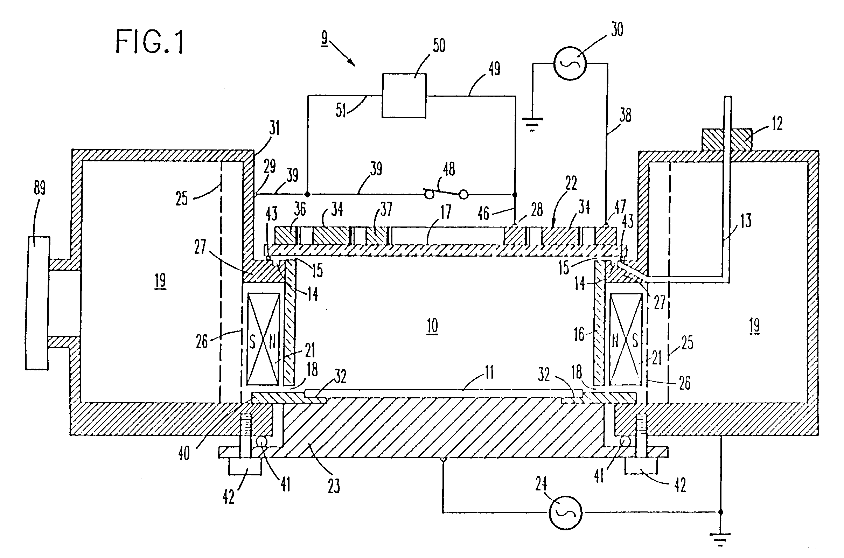

FIG. 1 shows apparatus 9 which includes an evacuated chamber 10 containing a semiconductor wafer 11 that comprises a work piece to be treated with a plasma process. A gas is admitted to chamber 10 from annular manifold 14 via annular orifice 15. The gas is used to form a plasma for processing of wafer 11 by etching or deposition. A liner 16 forming a cylindrical outer wall contains the gas which is to be energized to form a plasma.

Preferably, liner 16 is composed of quartz or another material which is nearly, i.e. substantially, inert or noncontaminating to the plasma to be contained in plasma processing chamber 10. The cover 17 of the chamber 10 is composed of quartz also. Thus the chamber 10 is surrounded by quartz lined liner 16 and cover 17 on the sides and the top with the wafer 11 on the bottom. The wafer 11 is supported on metallic base 23, but is insulated therefrom by an insulating coating on the upper surface of base 23. A flat insulating ring 40 is provided on top of base 23 at the periphery of the wafer 11 and with an indentation 32 for supporting the edges of wafer 11. Ring 40 separates the plasma from the surfaces below, and it is shown shaped with indentation 32 to retain the wafer 11 in a central position at the base of chamber 10.

The gas is admitted to the chamber 10 from gas input port 12 through line 13 to annular manifold 14 formed by annular base 27 and the cover 17. The manifold 14 is about 0.275 inches (0.7 cm) deep. The manifold 14 is connected to chamber 10 through a circumferential, narrow annular orifice 15 of about 0.005 inches (0.0127 cm) which maintains sufficient pressure of the gas in manifold 14 that the gas is distributed at a relatively uniform pressure about the entire circumference of the top of chamber 10. The gas in manifold 14 passes through orifice 15 between the top of the lip of annular base 27 and the lower surface of cover 17 in substantially equal quantities per unit time all about the circumferential area, i.e. the periphery, at the top of chamber 10 so that the plasma will be more highly uniform within the chamber 10. Preferably, the pressure of the gas in chamber 10 is at a low pressure of about 1-5 mTorr (1,3 x 10⁻¹ to 6,5 x 10⁻¹Pa). The gas to be exhausted from chamber 10 passes through annular orifice 18 at the base of the liner 16 or between magnets 21 into exhaust vacuum pumping manifold 19 and out through port 89, which is connected to vacuum pumps (not shown for convenience of illustration).

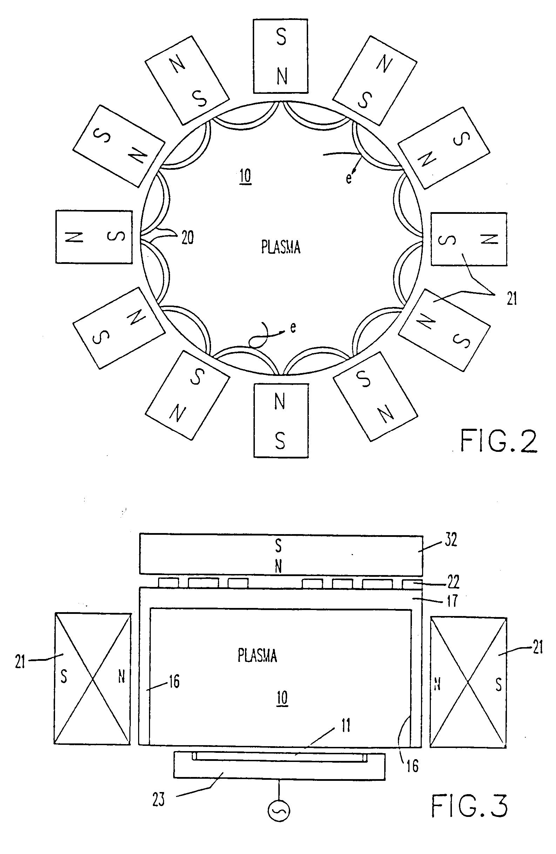

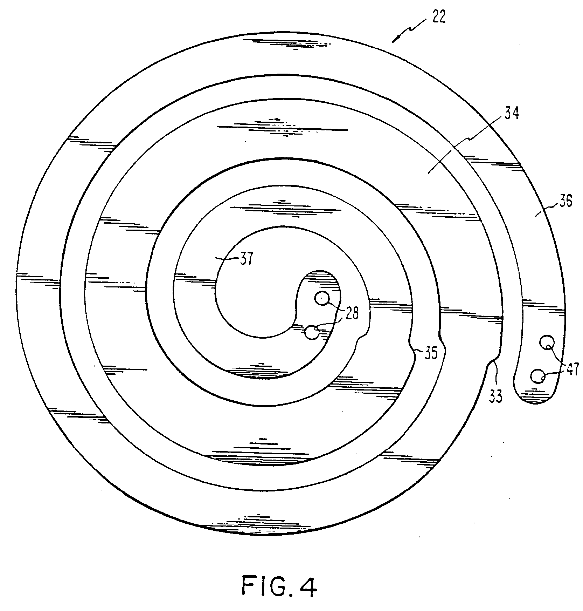

Apparatus to provide magnetic confinement of the plasma is employed in the form of multiple-magnetic-dipoles (multipoles) 21 with vertical axes as shown in FIGS. 1, 2 and 3. The multipoles 21 have their fields directed at right angles towards the vertical axis of the cylindrical chamber 10. Multipoles 21 are arranged about the periphery of liner 16 in the classic magnetic confinement cylindrical arrangement. The multipoles have their magnetic field directed inwardly as indicated by the plan view in FIG. 2. With this arrangement the alternating of the north and south poles (of multipoles 21) directed inwardly, looking down as in FIG. 2, provide a wall of magnetic field forces which repel electrons back into the interior of chamber 10, thereby reducing the number of activated ions striking the walls and varying the uniformity of concentration of the plasma near the wafer 11. As can be seen in FIG. 2, the magnetic field contains cusps 20 pointing towards the multipoles 21. It will be obvious to those skilled in the art that magnets 21 can provide cylindrical cusps instead of line cusps. A radio frequency induction (R.F.I.) coil 22 is wound in a spiral or involute form on top of quartz cover 17 of chamber 10 as shown in FIG. 4. The coil 22 is energized by a 13MHz radio frequency source 30 with a power of about 300 watts per amp of ions of the gas. Source 30 is connected by line 38 to the outer end of coil 22 at terminal 47. The other end of source 30 is also connected to ground completing the circuit. The inner end of spiral coil 22 is connected at terminal 28 by line 46 through switch 48 and line 39 to a bond 29 on the grounded wall 31 of apparatus 9 which is at electrical ground.

Referring to FIG. 3, for higher density plasmas, magnetic multipole confinement by magnets 32 located above cover 17 on its surface can be added adjacent to coil 22 to reduce the plasma loss to cover 17.

Switch 48 shorts out lines 49 and 51 which connect a reactance 50 in series with R.F. coil 22. Reactance 50 can be a variable or fixed reactance which is capacitive or inductive, as desired, to adjust the R.F. bias on the plasma. The connection of reactance 50 in series with coil 22, between terminal 28 and ground connection 29, is employed for the case where one is using the R.F. coil 22 alone, i.e. not using R.F. bias from source 24. Reactance 50 is useful in a case in which it is desired to use R.F. induction without the R.F. bias from source 24. In this case one can vary the ion energy over a somewhat smaller range 10eV to 80 eV. In accordance with this aspect of the invention one varies the impedance to ground (from the center of the coil 22, bypassing line 39 when switch 48 is opened to close the circuit to ground through reactance 50 and lines 49, 51 and 39 as well as bond 29). This allows one to go from the smallest amount of capacitive coupling (equivalent to middle turn 34 being at R.F. ground potential) with a value of capacitive impedance equal to one half of the coils inductive impedance to somewhat more capacitive coupling for reactance 50 being inductive.

Referring to FIG. 4, coil 22 includes a spiral with terminals, tapped holes comprising terminals 28 and 47 respectively for joining lines 28 and 38 to coil 22. Coil 22 is shown having three turns with the second (middle) turn 34 from transition 33 to transition 35 being substantially wider to enhance the inductive qualities of the coil 22. Both the outer turn 36 and the inner turn 37 are of about the same width. The advantage of this design is that the plasma is more uniform beneath the second (middle) turn 34 than it would be with a coil with a single width. In general this principle applies regardless of how many turns are involved. What is involved with the variation in width (i.e. cross-sectional area) is that the inductances of the three turns are rebalanced.

The R.F. energy from the coil 22 ionizes the gas in chamber 10 into a sustained plasma for additive or subtractive processing of the wafer 11. The wafer 11 is supported on metallic base 23. Metallic base 23 cools wafer 11 with electrostatic clamping and backside cooling not shown for convenience of illustration, but as is well understood by those skilled in the art. Base 23 is connected to an R.F. biasing source 24 at a frequency above about 13 MHz, preferably at 40 MHz which sets up an R.F. bias between the wafer 11 and the plasma, leading to a D.C. bias on the wafer 11. The use of different frequencies reduces coupling between the two power supplies. The high frequency R.F. bias gives a more monotonic distribution of ion energy, so there is improved control of ion energy for better selectivity of the rate of etching.

This R.F. bias provides ion energy control of the ions from the plasma as the R.F. level of the base 23 is varied by R.F. source 24. A dark space exists upon the upper surface of the wafer 11. The use of R.F. coil 22 instead of a capacitively coupled R.F. electrode to generate the plasma affords the advantage of reducing and controlling the kinetic energy of the ions striking the walls of liner 16 and wafer 11, thereby reducing the damage that can be done by ions and electrons at the high energy levels required for plasma processing contemplated for use with this apparatus. This also gives the flexibility of adjusting the ion energy according to process needs.

In the exhaust manifold or chamber 19 are located cylindrical walls of vertical screening 25 which extends from top to bottom in chamber 19 and a shorter wall of screening 26 which extends from the bottom of annular base 27 to the bottom of chamber 19. Screening 25 and 26 are included to provide grounded surfaces which will prevent the plasma from extending far into the manifold 19. Nylon bolts 42 secure base 23 to apparatus 9 with the O-ring gasket 41 sealing the chamber 10 from the atmosphere.

Gases suitable for use in forming the plasma are well known and some of them are listed as exemplary gases.
CCl₂F₂ + 20%SF₆
C₃F₈ + 16%SF₆
C₃F₈
CF₄
O₂
Ar + 10%O₂

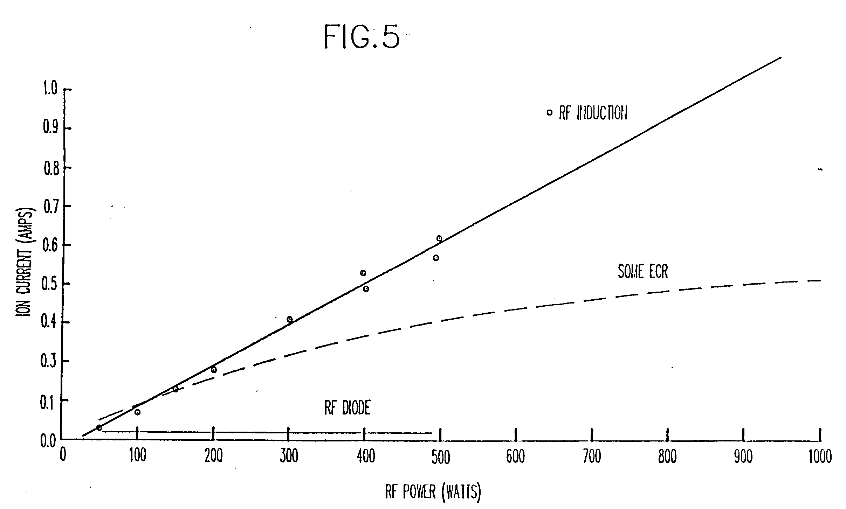

FIG. 5 is a graph of ion current vs R.F. power for three plasma processing systems. One curve is for R.F. power supplied to induction coil 22 employed in the instant embodiment, which produces a linear curve. As is well known to those skilled in the art, the dotted curve in FIG. 5 is for a system in which the plasma is generated by a particular electroncyclotronresonance (ECR) device.

The other dotted curve is for a system in which the plasma is formed by an R.F. diode, i.e. capacitively coupled R.F.. It can be seen that at higher power levels, the R.F. induction produces far higher ion current at a given power level plus a linear rate of increase which are both preferred characteristics. Ion current does not saturate as power increases, so very high plasma densities can be achieved at low ion kinetic energies.

This system and method is useful for both plasma etching and plasma coating processes, particularly in fields such as large scale integrated semiconductor devices and packages therefor. Other fields requiring microfabrication will also find use for this invention.

In plasma annealing of gate oxides or oxide isolation, one should avoid any peak-to-peak voltages above the "K alpha" energies of carbon, nitrogen and oxygen which are about 283, 401 and 532 respectively. Concomitantly, one desires a high density of atomic and ion hydrogen. This is is very difficult to achieve employing capacitively coupled R.F., even in the magnetron modes. We have found that it is easily achieved when employing an R.F. inductively coupled plasma.

This system can replace wet HF solutions for etching of thin layers.

## Claims

1. A plasma dry processing apparatus comprising:
a) a chamber (10) for plasma processing having an external wall, said chamber containing at least one work piece (11) having a surface to be processed in a plasma; and
b) induction means (22) comprising an induction coil for providing a radio frequency induction field within said chamber for generating a plasma within said chamber; said induction coil being located at an end of said chamber spaced substantially from said work piece; and
c) confining means (21) for providing a surface magnetic field for confining said plasma within said chamber; said confing means comprising multiple magnetic dipoles (21) with their fields directed inwardly towards the interior of said chamber with alternating north and south poles in a magnetic confinement cylindrical arrangement with their fields directed at right angles towards the vertical axis of said chamber, said surface magnetic field being substantially confined to the space adjacent to said external wall with said surface magnetic field extending from the exterior of said chamber to provide magnetic field cusps (20) proximate to the periphery of the interior of said external wall;
characterized in that said work piece is located at one end of said chamber and that said induction coil is an involute, spiral induction coil located at the other end on the exterior of said chamber;
whereby electrons are repelled to the interior of said chamber from motion towards the walls thereof to produce greater uniformity of the plasma near said work piece.

2. Apparatus according to claim 1 further including radio frequency energization means (30) for providing a R.F. generated bias to said work piece.

3. Apparatus according to claim 1 or 2 wherein said chamber (10) is lined with a liner material (16) substantially inert to a plasma or substantially noncontaminating to said work piece, and said induction means is located on the exterior of said liner material on said opposite end of said chamber from said work piece.

4. Apparatus according to claim 1 or 2 wherein means are provided for uniformly admitting a gas to said chamber comprising:
a) manifold means (14) located about the periphery of said chamber at the opposite end of said chamber from said work piece; and
b) orifice means (15) located between the surface of said chamber and said manifold means (14) for admitting said gas from said manifold into said chamber;
whereby said gas is admitted to said chamber from said manifold with a substantially uniform pressure so that said plasma will be uniform within said chamber.

5. Apparatus according to claim 2 including means (32) for providing a surface magnetic field positioned adjacent to said induction means.

6. Apparatus according to claim 1 including reactance means (50) connected in series with said induction means, whereby one can produce and adjust a radio frequency generated bias.

7. Apparatus according to claim 1 where said involute spiral coil (22) includes a larger cross section between the end windings thereof;
whereby more uniform plasma is produced adjacent to said larger cross section windings than a winding of uniform cross section.

## Patentansprüche

1. Trockene Plasmabearbeitungsvorrichtung, die folgendes beinhaltet:
a) eine Kammer (10) zur Plasmabearbeitung mit einer äußeren Wand, wobei die Kammer wenigstens ein Werkstück (11) mit einer in einem Plasma zu bearbeitenden Oberfläche enthält; und
b) Induktionsmittel (22), die eine Induktionsspule zur Bereitstellung eines Hochfrequenz-Induktionsfeldes innerhalb der Kammer zur Erzeugung eines Plasma innerhalb der Kammer beinhalten, wobei die Induktionsspule an einem Ende der Kammer mit einem beträchtlichen Abstand von dem Werkstück angeordnet ist; und
c) Begrenzungsmittel (21) zur Bereitstellung eines Oberflächenmagnetfeldes, um das Plasma innerhalb der Kammer begrenzt zu halten; wobei die Begrenzungsmittel mehrere magnetische Dipole (21) beinhalten, deren Felder nach innen zum Inneren der Kammer hin gerichtet sind, mit abwechselnden Nord- und Südpolen in einer zylindrischen Anordnung zur magnetischen Begrenzung, wobei deren Felder sich im rechten Winkel zur vertikalen Achse der Kammer erstrecken, wobei das Oberflächenmagnetfeld im wesentlichen auf den an die äußere Wand angrenzenden Raum begrenzt ist, wobei sich das Oberflächenmagnetfeld vom Äußeren der Kammer aus derart erstreckt, daß magnetische Feldspitzen (20) nahe der Peripherie der Innenseite der äußeren Wand bereitgestellt werden;
dadurch gekennzeichnet, daß sich das Werkstück an einem Ende der Kammer befindet und daß die Induktionsspule eine spiralförmige Evolventeninduktionsspule ist, die sich an dem anderen Ende auf dem Äußeren der Kammer befindet;
wodurch Elektronen, die sich in Richtung der Wände der Kammer bewegen, in das Innere derselben zurückreflektiert werden, um eine größere Gleichförmigkeit des Plasmas nahe des Werkstückes zu erzeugen.

2. Vorrichtung gemäß Anspruch 1, die des weiteren Hochfrequenzerregungsmittel (30) zur Bereitstellung einer HF-erzeugten Vorspannung für das Werkstück beinhaltet.

3. Vorrichtung gemäß Anspruch 1 oder 2, wobei die Kammer (10) mit einem Ummantelungsmaterial (16) eingefaßt ist, das gegenüber einem Plasma im wesentlichen inert ist oder das Werkstück im wesentlichen nicht kontaminiert, und wobei sich die Induktionsmittel auf der Außenseite des Ummantelungsmaterials an dem Ende der Kammer, das dem Werkstück gegenüberliegt, befinden.

4. Vorrichtung gemäß Anspruch 1 oder 2, wobei Mittel zum gleichmäßigen Einlassen eines Gases in die Kammer vorgesehen sind, die folgendes beinhalten:
a) Verteilermittel (14), die sich entlang des Umfangs der Kammer an dem Ende der Kammer, das dem Werkstück gegenüberliegt, befinden; und
b) Öffnungsmittel (15), die sich zwischen der Oberfläche der Kammer und den Verteilermitteln (14) befinden, um das Gas von den Verteilermitteln in die Kammer einzulassen;
wodurch das Gas von dem Verteiler mit einem im wesentlichen gleichmäßigen Druck in die Kammer eingelassen wird, so daß das Plasma innerhalb der Kammer gleichförmig ist.

5. Vorrichtung gemäß Anspruch 2, die Mittel (32) zur Bereitstellung eines Oberflächenmagnetfeldes beinhaltet, die benachbart zu den Induktionsmitteln positioniert sind.

6. Vorrichtung gemäß Anspruch 1, die Reaktanzmittel (50) beinhaltet, die seriell mit den Induktionsmitteln verbunden sind, wodurch eine mit Hochfrequenz erzeugte Vorspannung erzeugt und eingestellt werden kann.

7. Vorrichtung gemäß Anspruch 1, wobei die spiralförmige Evolventenspule (22) zwischen ihren Endwindungen einen größeren Querschnitt aufweist;
wodurch angrenzend an die Windungen mit größerem Querschnitt ein gleichförmigeres Plasma erzeugt wird als mit einer Windung mit gleichmäßigem Querschnitt.

## Revendications

1. Appareil de traitement à sec par plasma comprenant:
a) une chambre (10) pour un traitement par plasma ayant une paroi extérieure, ladite chambre contenant au moins une pièce à usiner (11) ayant une surface à traiter dans un plasma; et
b) un moyen d'induction (22) comprenant un bobinage d'induction pour fournir un champ d'induction radiofréquence à l'intérieur de ladite chambre pour générer un plasma à l'intérieur de ladite chambre; ledit bobinage d'induction étant situé à une extrémité de ladite chambre dans une position espacée de ladite pièce à usiner; et
c) un moyen de confinement (21) pour fournir un champ magnétique de surface pour confiner ledit plasma à l'intérieur de ladite chambre; ledit moyen de confinement comprenant de multiples dipôles magnétiques (21) avec leurs champs magnétiques dirigés vers l'intérieur vers l'intérieur de ladite chambre avec des pôles nord et sud alternés dans un agencement cylindrique de confinement magnétique, leurs champs étant dirigés à angles droits vers l'axe vertical de ladite chambre, ledit champ magnétique de surface étant sensiblement confiné dans l'espace adjacent à ladite paroi extérieure, ledit champ magnétique de surface s'étendant depuis l'extérieur de ladite chambre pour fournir des points de rebroussement (20) de champ magnétique à proximité de la périphérie de l'intérieur de ladite paroi extérieure;
caractérisé en ce que ladite pièce à usiner est située à une extrémité de ladite chambre et en ce que ledit bobinage d'induction est un bobinage d'induction en spirale développante situé à l'autre extrémité à l'extérieur de ladite chambre;
à la suite de quoi des électrons sont repoussés vers l'intérieur de ladite chambre à partir d'un mouvement vers les parois de celle-ci pour produire une uniformité supérieure du plasma près de ladite pièce à usiner.

2. Appareil selon la revendication 1 comprenant en outre un moyen (30) d'excitation radiofréquence pour fournir une polarisation générée par R F à ladite pièce à usiner.

3. Appareil selon la revendication 1 ou 2 dans lequel ladite chambre (10) est protégée par un matériau isolant (16) sensiblement inerte à un plasma ou sensiblement sans contamination de ladite pièce à usiner, et ledit moyen d'induction est situé à l'extérieur dudit matériau d'isolant sur l'extrémité opposée de ladite chambre depuis ladite pièce à usiner.

4. Appareil selon la revendication 1 ou 2 dans lequel un moyen est utilisé pour admettre un gaz de manière uniforme dans ladite chambre comprenant:
a) un moyen (14) formant tubulure situé autour de la périphérie de ladite chambre à l'extrémité opposée de ladite chambre par rapport à ladite pièce à usiner; et
b) un moyen (15) formant orifice situé entre la surface de ladite chambre et ledit moyen (14) formant tubulure pour admettre ledit gaz à partir de ladite tubulure dans ladite chambre;
à la suite de quoi ledit gaz est admis dans ladite chambre à partir de ladite tubulure avec une pression sensiblement uniforme de telle sorte que ledit plasma sera uniforme à l'intérieur de ladite chambre.

5. Appareil selon la revendication 2 comportant un moyen (32) pour fournir un champ magnétique de surface disposé dans une position adjacente audit moyen d'induction.

6. Appareil selon la revendication 1 comportant un moyen de réactance (50) connecté en série avec ledit moyen d'induction, à la suite de quoi on peut produire et régler une polarisation générée en radiofréquence.

7. Appareil selon la revendication 1 où ledit bobinage en spirale de développante (22) comporte une section transversale supérieure entre les enroulements de celui-ci;
à la suite de quoi un plasma plus uniforme est produit dans une position adjacente à ladite section transversale auxdits enroulements de section transversale plus importante qu'un enroulement de section transversale uniforme.
